# EUROPÄISCHE PATENTSCHRIFT

(11) **EP 2 449 761 B1**
(45) Veröffentlichungstag und Bekanntmachung des Hinweises auf die Patenterteilung: **21.08.2013**
(21) Anmeldenummer: 10726960.7
(22) Anmeldetag: 23.06.2010
(51) Int. Cl.: B60R 11/04, H04N 5/225, H04N 5/232

(54) **KAMERA FÜR EIN FAHRZEUG**
CAMERA FOR A VEHICLE
CAMÉRA POUR UN VÉHICULE

(30) Priorität: 01.07.2009 DE 102009027372
(43) Veröffentlichungstag der Anmeldung: 09.05.2012
(73) Patentinhaber: Robert Bosch GmbH, 70442 Stuttgart (DE)
(72) Erfinder: KARL, Matthias, 76275 Ettlingen (DE)
(86) Internationale Anmeldenummer: PCT/EP2010/058872
(87) Internationale Veröffentlichungsnummer: WO 2011/000746

(56) Entgegenhaltungen:
- EP-A1- 1 764 835
- US-A1- 2006 138 498
- US-A1- 2008 142 685

## Beschreibung

### Stand der Technik

Videosysteme in Fahrzeugen werden insbesondere zur Realisierung unterschiedlicher primärer Fahrerassistenzsysteme, z. B. von Nachtsichtsystemen, wamenden Videosystemen, Spurerkennung, Lichtassistent usw. eingesetzt. Die Kamera erfasst hierbei eine Fahrzeugumgebung durch eine Fahrzeugscheibe, insbesondere die Frontscheibe hindurch. Hierbei wird im allgemeinen die Gegenstandsweite unendlich eingestellt. Weitere Bereiche mit endlicher Gegenstandsweite werden somit allenfalls unscharf abgebildet.

Weiterhin ist der Einsatz von Kameras für sekundäre Funktionen, z. B. der Detektion von Regentropfen auf der Scheibenaußenseite bekannt, wozu im allgemeinen Licht, insbesondere IR-Strahlung, in die Scheibe eingestrahlt und über den Imager der Kamera detektiert wird. Hierbei kann ein separater Imagerbereich für diese Strahlung vorgesehen sein. derartige Systeme erfordern jedoch einen fahrzeugspezifischen bzw. scheibenspezifischen Zusatzaufwand.

Die US 2007/0096010 A1 zeigt einen multifunktionalen optischen Sensor als CCD- oder CMOS-Element, dessen sensitive Fläche in Teilbereiche unterteilt ist, die für unterschiedliche Funktionen vorgesehen sind. Hierbei sind Mikrolinsen oder Mikroprismen vor die einzelnen Pixel gesetzt, um gewünschte Abbildungseigenschaften, insbesondere Fokussierungseigenschaften zu erreichen. Somit wird die gesamte Optik durch diese Mikrolinsen oder Mikroprismen gebildet. Hierfür sind jedoch z.T. sehr aufwändige und fahrzeugspezifische Ausbildungen z. B. der Mikroprismen erforderlich.

Die Erfassung unterschiedlicher Erfassungsbereiche durch eine Kamera mit einem einheitlichen Imager ist z.B. auch aus der DE 103 23 560 A1 bekannt. Hierbei wird zum einen ein Bereich außerhalb des Fahrzeugs für Fahrerassistenzfunktionen über einen ersten Imagerbereich erfasst. Weiterhin wird über einen Spiegel, insbesondere einen Wölbspiegel, ein Bereich oberhalb des Fahrzeugs erfasst, insbesondere vertikal oberhalb. Hierdurch kann in Abhängigkeit der Bildsignale ein Helligkeitssignal erzeugt werden. Durch derartige Systeme sind bereits vielseitige Nutzungen eines einzigen Imager bzw. Bildsensors für mehrere Funktionen möglich. Allerdings ist ein erheblicher apparativer Aufwand durch z.B. externe bzw. vor dem Objekt der Kamera vorgesehene zusätzliche Wölbspiegel oder andere optische Einrichtungen erforderlich.

Die EP 1 764 835 A1 beschreibt eine Kamera gemäß dem einleitenden Teil von Anspruch 1. Eine sensitive Fläche ist in Sub-Bereiche unterteilt, die spezifischen Funktionen zugeordnet sind. Vor jedes Pixel ist ein optisches Mikromittel gesetzt, das Licht auf das jeweilige Pixel bündelt.

Die US 2008/142685 A1 zeigt einen integrierten Image-Sensor zur farbdifferenzierten Aufnahme. Vor die einzelnen Pixel sind Mikrolinsen mit farbfilternder und fokussierender Wirkung gesetzt.

### Offenbarung der Erfindung

Erfindungsgemäß ist zwischen dem Objektiv und dem Imager eine Zusatzoptik vorgesehen, die für unterschiedliche Imagerbereiche bzw. Teilbereiche der sensitiven Fläche des Imagers unterschiedliche Abbildungseigenschaften oder Abbildungsfunktionen aufweist. Diese unterschiedlichen Abbildungseigenschaften sind unterschiedliche Brennweiten und/oder Gegenstandsweiten.

Somit wird erfindungsgemäß durch die optische Anordnung aus dem Objektiv und der nachgeordneten Zusatzoptik für unterschiedliche Imagerbereiche bzw. Teilbereiche des Imagers unterschiedliche Brennweiten und/oder Gegenstandsweiten ausgebildet.

Die unterschiedlichen Imagerbereiche entsprechen hierbei unterschiedlichen Erfassungsbereichen der Kamera. Somit können mit demselben Imager in den unterschiedlichen Imagerbereichen unterschiedliche Funktionen durchgeführt werden. Hierbei wird ein einheitliches Objektiv für den gesamten Imager verwendet, wobei unterschiedliche Fokussierungen bzw. die Kompensation unterschiedlicher Bildebenen aufgrund der unterschiedlichen Gegenstandsweiten durch die Zusatzoptik erreicht wird.

Die Zusatzoptik kann vorteilhafterweise direkt auf dem Imager bzw. dem Imagerträger befestigt sein. Sie weist als optische Mikroelemente lichtleitende Einrichtungen z. B.

Lichtleitröhren und reflektierende Trennwände auf, die jeweils spezifisch für einen Pixel oder auch mehrere Pixel gewünschte Abbildungseigenschaften erreichen. Insbesondere können die optischen Mikroelemente jeweils einem einzigen Pixel zugeordnet sein und für die unterschiedlichen Teilbereiche bzw. Imagerbereiche unterschiedliche optische Mittel vorgesehen sein.

Die Zusatzoptik ist somit anders als in z.B. der DE 103 23 560 A1 nicht vor dem Objektiv, sondern zwischen dem Objektiv und dem Imager, insbesondere direkt auf dem Imager oder Imagerträger vorgesehen, wobei vorzugsweise auf unterschiedliche Gegenstandsweiten fokussiert wird. Anders als in US 2007/0096010 A1 ist ein zusätzliches Objektiv vorgesehen.

Erfindungsgemäß ist ein Imagerbereich ohne Mikroelemente und ein anderer mit Mikroelementen ausgestattet sein.

Gemäß einer besonders bevorzugten Ausbildung können die optischen Mikromittel unterschiedliche Bildebenen kompensieren, die sich aufgrund unterschiedlicher Gegenstandsweiten der verschiedenen Erfassungsbereiche, insbesondere einer Gegenstandsweite unendlich und einer endlichen Gegenstandsweite ergeben. So kann z. B. ein erster Imagerbereich der Gegenstandsweite unendlich und ein zweiter Imagerbereich einer endlichen Gegenstandsweite zugeordnet sein, wobei dann der zweite Imagerbereich eine nach hinten versetzte Bildebene aufweist, die erfindungsgemäß durch eine stärkere Fokussierung der optischen Mittel bzw. Mikromittel der Zusatzoptik kompensiert wird.

Erfindungsgemäß werden einige Vorteile erreicht. So ist die Verwendung einer Kamera mit einem einfachen Objektiv ohne aufwendige zusätzliche Mittel möglich, z. B. lediglich mit einem zusätzlichen an einer Streublende befestigten Spiegel zur Umlenkung des Erfassungsbereichs. Es kann somit eine Kamera mit Kamerahalterung für unterschiedliche Fahrzeugtypen vorgesehen sein, wobei lediglich der Imager spezifisch anzupassen ist, oder es kann sogar auch ein einheitlicher Imager für unterschiedliche Fahrzeuge verwendet werden, indem eine Fokussierung bzw. Justage auf einen relevanten Bereich wie z.B. die Scheibenoberfläche erfolgt, indem bei eingeschaltetem Imager der relevante Bereich scharf gestellt wird, indem entweder die Kamera mitsamt Kameragehäuse in der Kamerahalterung verstellt wird und/oder die Kombination von Imager und Objektiv innerhalb des Kameragehäuses, das gegenüber der Scheibe fest angeordnet ist, verstellt wird. Alternativ oder zusätzlich hierzu können auch auf der Zusatzoptik mehrere optische Mikromittel, mit unterschiedlichen Gegenstandsweiten nebeneinander vorgesehen sein, von denen dann immer eines richtig fokussiert.

Vorteilhaft ist auch, dass die Zusatzoptik keinen zusätzlichen Bauraum benötigt, leicht montierbar und intolerant gegenüber Tiefeschärfeschwankungen ist. Weiterhin wird erfindungsgemäß die primäre Fahrerassistenzfunktion durch die Sekundärfunktion nicht gestört.

Ein weiterer Vorteil liegt darin, dass die Anforderungen an die mechanischen Toleranzen der erfindungsgemäßen Zusatzoptik nicht so hoch sind wie bei der ausschließlichen Verwendung von imagemahen optischen Mitteln wie z.B. Mikrolinsen. So kann z.B. durch zusätzliche optische Mittel bzw. Mikromittel, die mehrere Pixel übergreifen, eine größere Unempfindlichkeit gegenüber Fertigungstoleranzen erreicht werden. Derartige zusätzliche optische Mittel dürften wegen ihrer Nähe bzw. technischen Ähnlichkeit zu bisher üblichen Strukturen von Mikrolinsen mit relativ geringem Änderungsaufwand aus einer laufenden Serienfertigung abgeleitet werden.

Das erfindungsgemäße System ist auch vorteilhaft gegenüber Systemen mit einer Fokussierung durch vor das Objektiv gesetzte Vorsatzoptiken mit unterschiedlichen Gegenstandsweiten, da derartige Systeme relativ aufwendig und für jeweils spezifische Fahrzeugscheiben bzw. Fahrzeuge auszulegen sind, was zu einem entsprechenden Kostenaufwand führt.

Erfindungsgemäß kann als Primärfunktion insbesondere eine Außenraumüberwachung bzw. Erfassung der Kameraumgebung für verschiedene Fahrerassistenzsysteme, insbesondere Nachtsichteinrichtung, Spurerkennung, Verkehrsraumüberwachung wie z.B. Erfassung weiterer Teilnehmer, Lichtassistent, Trajektorienerkennung, Erkennung von Verkehrszeichen usw. durchgeführt werden. Die zusätzliche Funktion bzw. Sekundärfunktion kann insbesondere die Erfassung der Scheibenaußenseite sein, z.B. für Regendetektion oder Erkennung eines Beschlags. Somit wird der zweite Teilbereich für diese zweite Funktion auf eine deutlich kürzere Gegenstandsweite fokussiert werden, was mit der erfindungsgemäßen Zusatzoptik geeignet erreicht werden kann.

### Kurze Beschreibung der Zeichnungen

- Fig. 1: zeigt eine Kamera gemäß einer erfindungsgemäßen Ausführungsform bei Anbringung an einer Fahrzeugscheibe;
- Fig. 2: zeigt eine schematische Darstellung des optischen Strahlengangs der erfindungsgemäßen Kamera;

- Fig. 3: zeigt eine Ausführungsform der Zusatzoptik mit reflektierenden Trenn-wänden,und
- Fig. 4: zeigt eine Ausführungsform der Zusatzoptik mit einem Bündel aus Lichtleitern;
- Fig. 5: zeigt eine Druntersicht der Fig. 4, und
- Fig. 6: zeigt eine Druntersicht einer gegenüber Fig. 4 abgewandelten Ausführungsform mit mehreren Lichtleitröhren je Photodiode.

### Beschreibung der Ausführungsformen

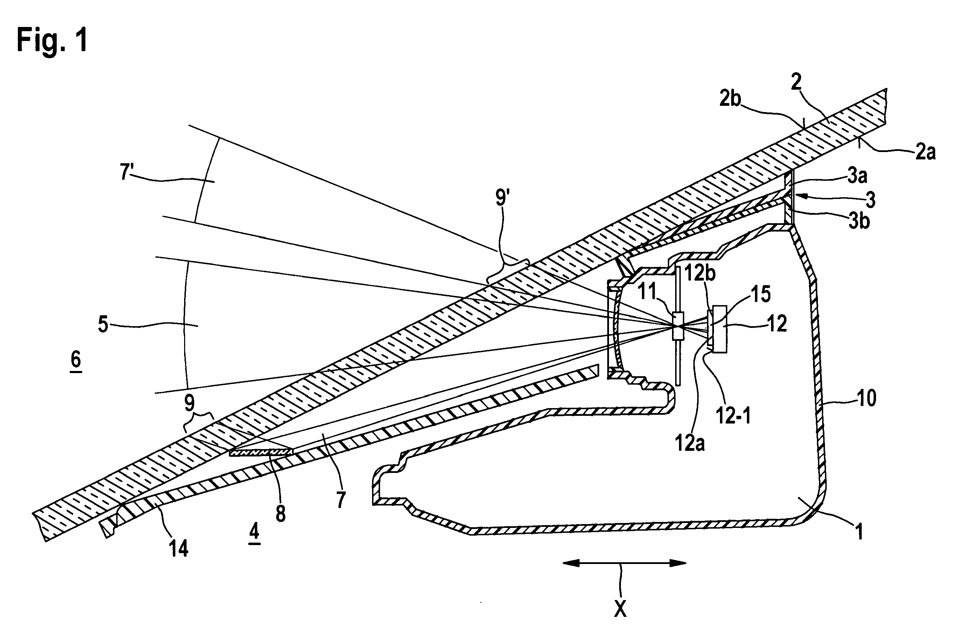

Gemäß Fig. 1 ist eine Kamera 1 an einer Scheibeninnenseite 2a einer Fahrzeugscheibe 2 angebracht. Hierzu kann eine Kamerahalterung 3 vorgesehen sein, die eine Verstellung der Kamera 1 z.B. in Fahrzeuglängsrichtung bzw. X-Richtung des Fahrzeugs oder auch einer hiervon etwas abweichenden Richtung ermöglicht, z. B. auch in der X-Z-Ebene, wobei Z die vertikale Richtung bzw. Fahrzeug-Hochrichtung ist. In Fig. 1 ist hierzu schematisch ein an der Fahrzeugscheibe 2 befestigter äußerer Halterahmen 3a und ein in diesem verstellbares Rahmeninnenteil 3b dargestellt, die zusammen den Halterahmen 3 bilden. Relevant ist, dass eine Verstellung der Kamera 1 nicht nur parallel zur Fahrzeugscheibe 2, sondern auch nicht-parallel hierzu möglich ist. Die Fahrzeugscheibe 2 kann insbesondere die Frontscheibe, aber z. B. auch die Heckscheibe sein.

Die Kamera 1 ist innerhalb des Fahrzeuginnenraums 4 angebracht. Sie erfasst in einem ersten Erfassungsbereich 5, der im wesentlichen einen Raumwinkel darstellt, einen Teil der Fahrzeugumgebung 6 für verschiedene Primärfunktionen und in einem zweiten Erfassungsbereich 7 einen Bereich 9 der Scheibenaußenseite 2b für eine oder mehrere Sekundärfunktionen. Hierbei kann der erste Erfassungsbereich 5 für verschiedene Fahrerassistenzsysteme dienen, insbesondere die Erfassung eines Teils der Fahrzeugumgebung 6 zur Darstellung auf einer Anzeigeeinrichtung, insbesondere auch für ein Nachtsichtsystem, und/oder zur Abstandsdetektion, Spurdetektion, Verkehrszeichenerkennung sowie Erfassung von weiteren Verkehrsteilnehmern. Über den zweiten Erfassungsbereich 7 kann als Sekundärfunktion insbesondere die Detektion der Scheibenaußenseite 2b der Fahrzeugscheibe 2 ermöglicht werden, z.B. als Regendetektor bzw. Detektion von relevanten Belägen auf der Scheibenaußenseite 2b.

Die Kamera 1 weist ein Kameragehäuse 10, ein Objektiv 11 mit z.B. einer geeigneten Linsenanordnung, und einen Imager 12 bzw. Imagerchip auf, der als CCD-oder CMOS-Baustein in bekannter Weise eine sensitive Fläche mit einer Pixelanordnung aufweist. Weiterhin ist eine Streulichtblende 14 vorgesehen, die zwischen der Kamera 1 und der Scheibeninnenseite 2a der Fahrzeugscheibe 2 angebracht ist. Der Imager 12 weist somit auf seiner sensitiven Oberfläche 12-1 einen ersten Imagerbereich12a für den ersten Erfassungsbereich 5 und einen zweiten Imagerbereich12b für den erfassten Bereich 9 der Scheibenaußenseite 2b auf.

Die Erfassungsbereiche 5 und 7 können durch zusätzliche optische Mittel außerhalb der Kamera 1 weiter festgelegt sein. Gemäß Fig. 1 ist ein Spiegel 8 vor der Kamera 1 vorgesehen, z.B. an der Streulichtblende 14 angebracht, der den Erfassungsbereich 7 nach oben und/oder vorne umlenkt. Erfindungsgemäß kann der Spiegel 8 hierbei plan ausgebildet sein und somit die Fokussierung nicht ändern.

Bei der gezeigten Verwendung des Spiegels 8 liegt der zweite Erfassungsbereich 7 unterhalb des ersten Erfassungsbereichs 5 und ist der zweite Imagerbereich 12b auf der sensitiven Oberfläche 12-1 des Imagers 12 oberhalb des ersten Imagerbereichs 12a angeordnet. Ergänzend ist die Ausbildung einer geänderten Ausführungsform eingezeichnet, ber der kein Spiegel 8 vorgesehen ist; in diesem Fall ist der zweite Erfassungsbereich 7' oberhalb des ersten Erfassungsbereichs 5 angeordnet und erfasst einen Bereich 9'auf der Scheibenaußenseite 2b, wobei dann anders als gezeigt der zweite Imagerbereich 12b unterhalb des ersten Imagerbereichs 12a angeordnet ist.

Erfindungsgemäß ist in der Kamera 1 zwischen dem Objektiv 11 und dem Imager 12 eine Zusatzoptik 15 nahe am Imager 12 vorgesehen, die gemäß unterschiedlicher Ausführungsformen in den nachfolgenden Figuren detaillierter beschrieben ist.

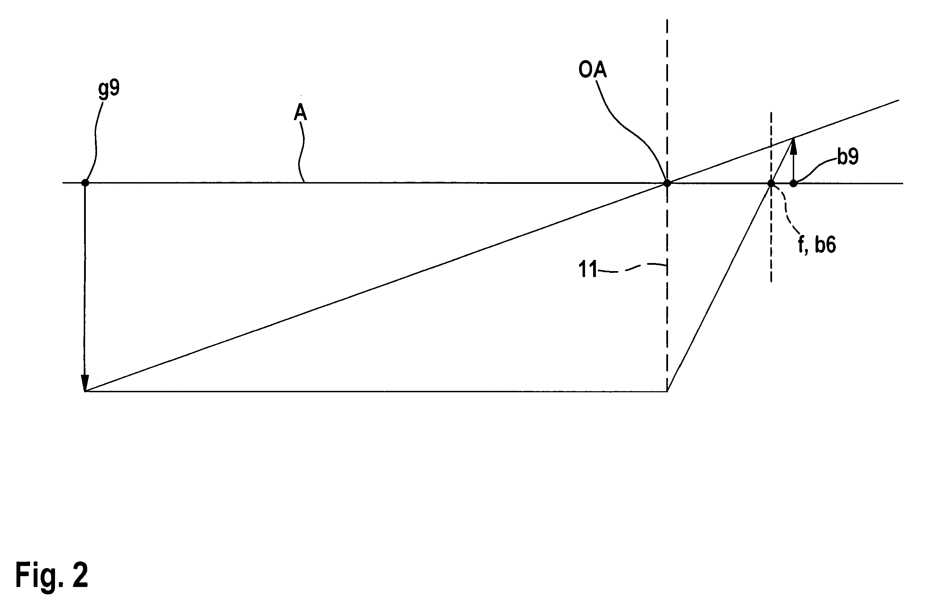

Fig. 2 zeigt die erfindungsgemäße Grundüberlegung bzw. das Wirkungsprinzip der erfindungsgemäßen imagernahen Zusatzoptik 15.

In Fig. 2 ist schematisch auf der optischen Achse A im Nullpunkt 0 das Objektiv 11 - vereinfacht als senkrecht zur optischen Achse A liegende Ebene - eingezeichnet, und die Brennweite f des Objektivs 11, das als Primäroptik wirkt und in Fig. 2 zunächst betrachtet wird. Weiterhin sind eine Gegenstandsweite g9 des Bereichs 9 der Scheibenaußenseite 2b sowie die zugehörige Bildweite b9 eingezeichnet. Ein Gegenstand in dem Bereich 9, z.B. ein Regentropfen, wird somit in bekannter Weise gemäß dieser Darstellung des optischen Strahlengangs auf die Bildweite b9 abgebildet.

Weiterhin erfasst die Kamera 1 in ihrem ersten Erfassungsbereich 5 Bereiche der Fahrzeugumgebung 6 mit Gegenstandsweite unendlich, die somit auf eine kürzere Bildweite b6 abgebildet werden, die somit zunächst mit der Brennweite f des Objektivs 11 übereinstimmt, wenn die Zusatzoptik 15 als Sekundäroptik nicht berücksichtigt wird. Hierbei sind die dargestellten Winkel und Größenverhältnisse etwas überzeichnet, um das zugrunde liegende Prinzip verdeutlicht hervorzuheben. Der in Fig. 2 gezeigte optische Strahlengang verdeutlicht, dass durch die unterschiedlichen Gegenstandsweiten der beiden Erfassungsbereiche 5 und 7 bei dem gemeinsamen Objektiv 11 versetzte Bildebenen entstehen. Erfindungsgemäß wird dies durch die als Sekundäroptik wirkende Zusatzoptik 15 ausgeglichen bzw. kompensiert, so dass sowohl der Bereich 9 der Scheibenaußenseite 2b als auch die Fahrzeugumgebung 6 mit Gegenstandsweite unendlich gemeinsam auf dem Imager 12 abgebildet werden können. Hierzu ist erfindungsgemäß die Zusatzoptik 15 zwischen dem Objektiv 11 und dem Imager 12 vorgesehen, wobei sie insbesondere direkt auf der Oberfläche des Imagers 12 angebracht ist.

Die Zusatzoptik 15 ist für die Teilbereiche 12a und 12b der sensitiven Oberfläche 12-1 des Imagers 12 unterschiedlich ausgebildet und lässt sich somit in erste optische Zusatzmittel 15a und zweite optische Zusatzmittel 15b unterteilen, die unterschiedlich ausgebildet sind, wobei z. B. auch eine der beiden, insbesondere die ersten optischen Zusatzmittel 15a, entfallen können und dann die zweiten optischen Zusatzmittel 15b eine stärkere Fokussierung bewirken, um die zweite Bildebene nach vorne auf die sensitive Oberfläche 12-1 des Imagers 12 zu verlegen. Die Zusatzmittel 15a, 15b sind hierbei vorteilhafterweise in den Ausführungsformen optische Mikromittel.

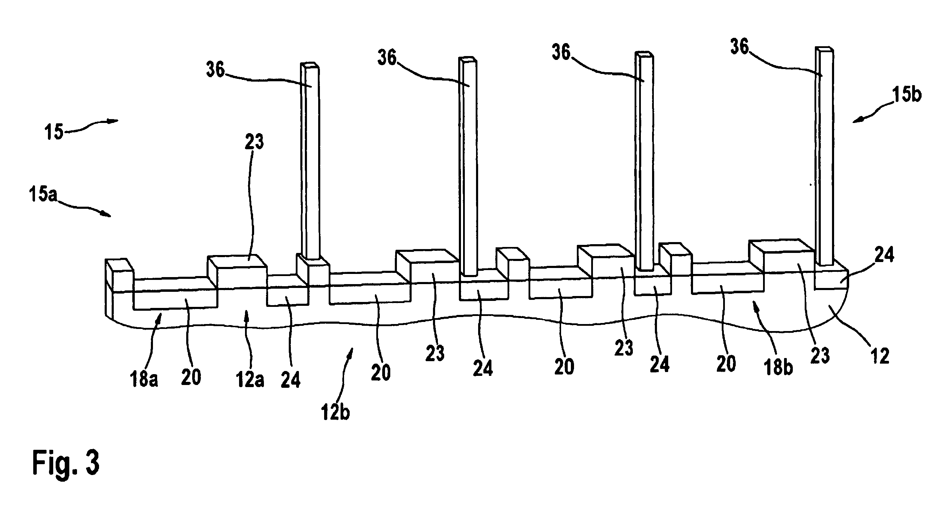

Die Zusatzoptik 15 ist vorteilhafterweise pixelspezifisch ausgebildet und weist Mittel auf, die jeweils einen einzigen Pixel oder auch mehrere Pixel erfassen bzw. ihnen zugeordnet sind. Die Figuren 3 bis 13 zeigen entsprechende Ausbildungen.

. Grundsätzlich ist hierbei die Ausbildung des Imagers 12 als CMOS oder auch CCD-Bauelement möglich. Die Pixel 18a, b können insbesondere mit unterschiedlichen Farbfiltern versehen, um eine farbliche Differenzierung für entsprechende Funktionen zu ermöglichen, z. B. als Bayer-Pattern.

Lichtleitröhren Z6 können z.B. als Vollzylinder aus transparentem Material oder auch als Hohlzylinder ausgebildet sein; insbesondere ist eine Ausbildung mit Glasfasern 26 als Lichtleitröhren möglich.

In der Anordnung der Fig. 1 kann z. B. die Brennweite f des Objektivs 11 als primärer Fixfokusoptik vor dem Imager 12 den Wert f= 7 mm und der Imager 12 bzw. die sensitive Oberfläche 12-1 eine Höhe B= 512 x 5,6 µm = 2,87 mm aufweisen, wobei auf dem zweiten Imagerbereich 12b der Bereich 9 scharf abgebildet wird. Somit steht für das Primärbild eine Höhe von Bp = 482 x 5,6 µm = 2,70 mm zur Verfügung. Der Abstand bzw. Bildweite b zwischen der primären Fixfokusoptik des Objektivs 11 und dem Imager 12 wird durch die Brennweite f und dem gewünschten optimalen Schärfeabstand, d.h. der Gegenstandsweite/Objektweite g bestimmt. Es gilt: 1/f = 1/b + 1/g, d.h. b = fg/(g-f) ≈ f für g>> f, d.h. g sehr groß gegen f, was bei Fahrerassistenzfunktionen mit g = 20.000 mm erreicht ist.

Der Abstand bzw. die Gegenstandsweite gs zum Bereich 9 der Scheibenaußenseite 2b ist hingegen erheblich geringer, z. B. gs = 80 mm. Somit ist bei unverändertem Abstand b des Imagers 12 zum Objektiv 11 für die Brennweite f_{R} der resultierenden optischen Gesamtanordnung 11, 15 anzusetzen 1/ f_{R} = 1/b + 1/gs , d.h. f_{R} = 1/ (1/gs + 1/b) = 1/ (1/gs + (1/f - 1/g)) ≈ 6,439 mm.

Die erfindungsgemäß Fokussierung erfolgt somit durch Verstellen der Kamera 1 mitsamt Rahmeninnenteil 3b gegenüber dem an der Fahrzeugscheibe 2 angebrachten Halterahmen 3a und/oder durch Verstellen der optischen Anordnung aus Objektiv 11 mitsamt Imager 12 und Zusatzoptik 15 in dem Kameragehäuse 10 in einer Richtung, die nicht parallel zur Fahrzeugscheibe 2 ist, d.h. nicht nur in Y-Richtung (Fahrzeugquerrichtung) und nicht entlang der Fahrzeugscheibe 2. Sie kann insbesondere in X-Richtung, d.h. nach vorne und hinten erfolgen. Hierbei wird das Bildsignal des Imagers 12 bzw. des zweiten Imagerbereichs 12b aufgenommen und auf ein Objekt in dem Bereich 9 scharf gestellt.

In Figur 3 ist der erste Imagerbereich 12a der Imager- Oberfläche 12-1 des Imagers 12 mit den ersten Pixeln 18a unverändert, um verschiedene weitere Ausführungsformen des zweiten Imagerbereichs 12b zu zeigen.

Gemäß der Ausführungsform der Fig. 3 sind im zweiten Imagerbereich 12b reflektierende Trennwände 36 um die zweiten Pixel 18b herum bzw. zwischen diesen angeordnet, die einfallendes Licht somit zu den Fotodioden 20 der jeweiligen zweiten Pixel 18b leiten. Die reflektierenden Trennwände 36 können insbesondere auch als Röhren bzw. Leitungsschächte mit z.B. rechteckigem Querschnitt ausgebildet sein. Sie können z.B. aus Metall ausgebildet sein und als Modul nachträglich aufgesetzt werden.

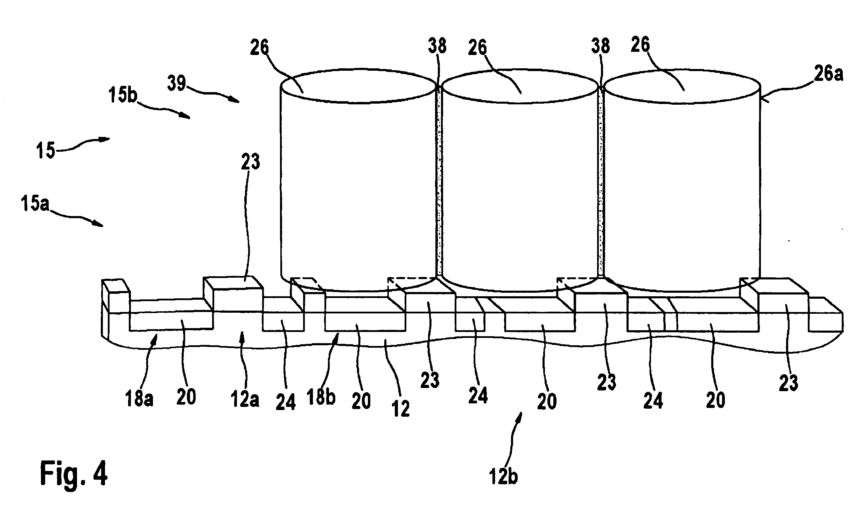

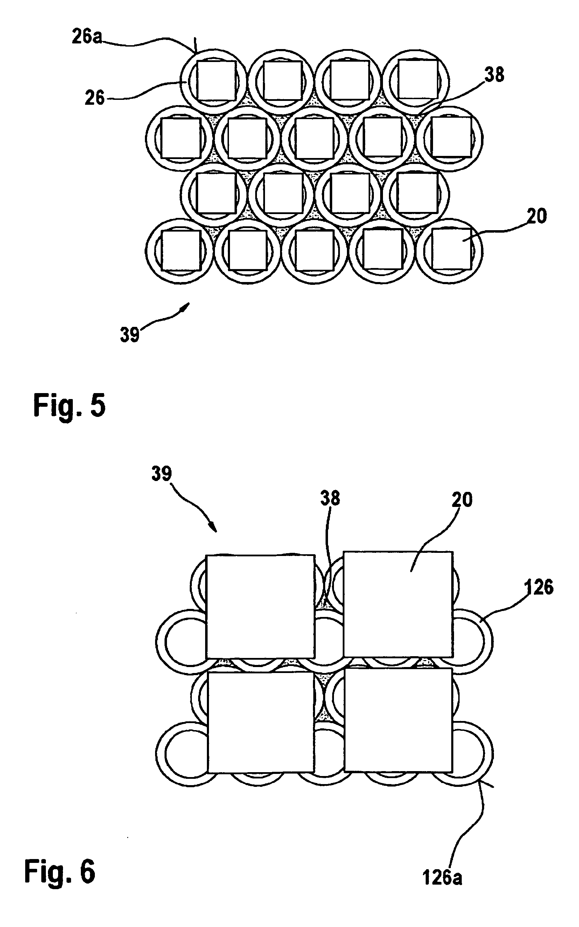

Bei der Ausführungsform der Fig. 4 bis 6 sind im zweiten Imagerbereich 12b als zweite optische Zusatzmittel mehrere Lichtleitröhren 26, insbesondere Glasfasern 26, vorgesehen. Die Ausführungsform der Fig 4 kann somit auch als eine optische Inversion der Fig. 3 interpretiert werden. Hierbei können Glasfasern 26 mit optisch undurchlässigen Mänteln 26a eingesetzt werden, die z. B. durch Färbung oder durch unterschiedliche Brechungsindizes ausgebildet werden können. Die Glasfasern 26 werden durch Klebstoff 38 miteinander zu dicken Strängen 39 verklebt. Von diesen Strängen 39 können dann Distanzstücke von der Dicke des zu verkürzenden Bildabstandes abgeschnitten werden, z. B. mittels eines Messers oder Lasers. Gemäß Fig. 5 kann bei geeigneter Wahl der Glasfaser 26 bzw. deren Manteldurchmessers je Fotodiode 20 genau eine Glasfaser 26 gesetzt werden. Vorteilhafterweise werden die Fotodioden 20 wie in Fig. 5 gezeigt gegeneinander versetzt.

Bei Fig. 5 ist eine relativ hohe Positioniergenauigkeit erforderlich. Alternativ hierzu kann gemäß der Ausführungsform der Fig. 6 der Durchmesser einer Glasfaser 126 deutlich kleiner als die Kantenlänge der Fotodiode 20 gewählt wird, so dass die Positioniergenauigkeit nicht mehr so hoch ist und weiterhin auch die Anforderungen an die optische Isolationswirkung zwischen den Glasfasern 126 herabgesetzt sind, da ein fehlerhaft verlaufender Lichtstrahl in Fig. 6 mehrere Mäntel 126a durchdringen muss, um auf einer anderen Fotodiode 20 störend zu wirken, wobei ein solcher querlaufender Lichtstrahl durch die in Reihe geschalteten Übergänge jeweils bedämpft wird.

Weiterhin kann jedoch auch der Durchmesser einer Glasfaser 26 größer als der Periodenabstand der Fotodioden 20 sein; diese Ausführungsform kann insbesondere für die Analyse der Scheibenoberfläche und/oder die Lichtdetektion eingesetzt werden, da die Auflösungsanforderungen nicht so hoch sind wie bei der Femfelddetektion.

## Patentansprüche

1. Kamera für ein Fahrzeug, insbesondere zur Außenraumbewachung, wobei die Kamera (1) aufweist:
einen Imager (12) mit mehreren Pixeln (18a, 18b) und
eine vor dem Imager (12) angeordnete, optische Mikroelemente (26, 36) aufweisende Zusatzoptik (15), die für unterschiedliche Imagerbereiche (12a, 12b) des Imagers (12) unterschiedliche Abbildungseigenschaften aufweist,
**dadurch gekennzeichnet, dass**
vor dem Imager (12) ein Objektiv (11) angeordnet ist,
wobei die Zusatzoptik (15) zwischen dem Objektiv (11) und dem Imager (12) vorgesehen ist,
wobei die optischen Mikroelemente lichdeitende Einrichtungen (26, 36, 126, 39) sind, die vor die Pixel (18a, 18b) eines zweiten Imagerbereichs (12b) gesetzt sind und einfallendes Licht zu einem oder mehreren Pixeln (18b) leiten,
wobei vor den Pixeln eines ersten Imagerbereichs (12a) keine optischen Mikroelemente angeordnet sind,
wobei durch die aus dem Objektiv (11) und der Zusatzoptik (15) gebildete optische Anordnung für die zwei verschiedenen Imagerbereiche (12a, 12b) jeweils zwei unterschiedliche Gegenstandsweiten (g9) so kompensiert werden, dass sie gemeinsam auf den Imager (12) abgebildet werden können.

2. Kamera nach Anspruch 1, **dadurch gekennzeichnet, dass** die Zusatzoptik (15) am Imager (11) oder einem Imagerträger befestigt ist.

3. Kamera nach einem der vorherigen Ansprüche, **dadurch gekennzeichnet, dass** der erste Imagerbereich (12a) zur Erfassung einer Fahrzeugumgebung (6) auf eine Gegenstandsweite unendlich und der zweite Imagerbereich (12b) auf eine endliche Gegenstandsweite , z.B. zur Erfassung einer Scheibenaußenseite (2b) einer Fahrzeugscheibe (2), gerichtet ist.

4. Kamera nach einem der vorherigen Ansprüche, **dadurch gekennzeichnet, dass** die lichtleitenden Einrichtungen (26, 36, 126) reflektierende Trennwände (36) oder Lichtleitröhren (26, 126) sind.

5. Kamera nach Anspruch 4, **dadurch gekennzeichnet, dass** die lichtleitenden Einrichtungen (26, 36, 126, 39) als Lichtleitröhren (26), z. B. Glasfasern (26) ausgebildet sind, die jeweils plane, in einer Ebene liegende Oberseiten aufweisen.

6. Kamera nach Anspruch 5, **dadurch gekennzeichnet, dass** die Zusatzoptik (15) ein oder mehrere Distanzstücke aufweist, die aus mehreren Glasfasern (26) durch Klebstoff (38) als Stränge verklebt sind.

7. Kameraanordnung aus einer Kamera (1) nach einem der vorherigen Ansprüche und einer Kamerahalterung (3) zur Anbringung an einer Fahrzeugscheibe (2), wobei zur Fokussierung oder Justage der Abbildung eines erfassten Bereiches (9) der Scheibenaußenseite (2b)
- die Kamera (1) an der Kamerahalterung (3) verstellbar ist, und/oder
- die Anordnung aus Objektiv (11) und Imager (2) innerhalb eines von der Kamerahalterung (3) getragenen Kameragehäuses (10) verstellbar ist.

8. Fahrzeug mit einer Fahrzeugscheibe (2), insbesondere Frontscheibe und einer an einer Scheibeninnenseite (2a) über eine Kamerahalterung (3) befestigten Kamera (1) nach einem der Ansprüche 1 bis 6, deren erster Imagerbereich (12a) über die Zusatzoptik (15) und das Objektiv (11) durch die Fahrzeugscheibe (2) hindurch einen ersten Erfassungsbereich (5) einer Fahrzeugumgebung (6) mit größerer Gegenstandsweite abbildet und deren zweiter Imagerbereich (12b) über die Zusatzoptik (15) und das Objektiv (11) einen Bereich (9) mit kleinerer Gegenstandsweite (g9), insbesondere einen Bereich (9) einer Scheibenaußenseite (2b) der Fahrzeugscheibe (2), abbildet.

9. Fahrzeug nach Anspruch 8 mit einer Kameraanordnung nach Anspruch 7, **dadurch gekennzeichnet, dass** zur Justage der Abbildung eines erfassten Bereiches (9) der Scheibenaußenseite (2b) die Kamera (1) an der Kamerahalterung (3) und/oder die Anordnung aus Objektiv (11) und Imager (2) innerhalb eines von der Kamerahalterung (3) getragenen Kameragehäuses (10) in einer Richtung (x) nicht parallel zur Scheibeninnenseite (2a) verstellbar ist.

## Claims

1. Camera for a vehicle, in particular for external surveillance, the camera (1) having:
an imager (12) with a plurality of pixels (18a, 18b),
and
an additional optics (15) which is arranged upstream of the imager (12) and has optical microelements (26, 36) and different imaging characteristics for different imager regions (12a, 12b) of the imager (12),
**characterized in that**
an objective (11) is arranged upstream of the imager (12),
the additional optics (15) being provided between the objective (11) and the imager (12),
the optical microelements being light-guiding devices (26, 36, 126, 39) which are set upstream of the pixels (18a, 18b) of a second imager region (12b) and guide incident light to one or more pixels (18b),
no optical microelements being arranged upstream of the pixels of a first imager region (12a), and
the optical arrangement for the two different imager regions (12a, 12b) formed from the objective (11) and
the additional optics (15) respectively compensates two different object distances (g9) such that they can be jointly imaged onto the imager (12).

2. Camera according to Claim 1, **characterized in that** the additional optics (15) is fastened on the imager (11) or an imager carrier.

3. Camera according to one of the preceding claims, **characterized in that** in order to detect a vehicle surroundings (6) the first imager region (12a) is directed to an object distance at infinity, and the second imager region (12b) is directed to a finite object distance, for example in order to detect an outside of the window (2b) of a vehicle window (2).

4. Camera according to one of the preceding claims, **characterized in that** the light-guiding devices (26, 36, 126) are reflecting partitions (36) or light-guiding tubes (26, 126).

5. Camera according to Claim 4, **characterized in that** the light-guiding devices (26, 36, 126, 39) are designed as light-guiding tubes (26), for example glass fibres (26) which respectively have planar top sides lying in a plane.

6. Camera according to Claim 5, **characterized in that** the additional optics (15) have one or more spacers which are bonded by adhesive (38) as strands from a plurality of glass fibres (26).

7. Camera arrangement comprising a camera (1) according to one of the preceding claims and a camera holder (3) for attachment to a vehicle window (2), in which in order to focus or adjust the imaging of a detected region (9) of the outside of the window (2b)
- the camera (1) can be adjusted on the camera holder (3), and/or
- the arrangement comprising objective (11) and imager (2) can be adjusted inside a camera housing (10) carried by the camera holder (3).

8. Vehicle having a vehicle window (2), in particular windscreen, and a camera (1), fastened on an inside of the window (2a) via a camera holder (3), according to one of Claims 1 to 6, whose first imager region (12a) images a first detection region (5) of a vehicle surroundings (6) with a larger object distance through the vehicle window (2) via the additional optics (15) and the objective (11), and whose second imager region (12b) images a region (9) with a smaller object distance (g9), in particular a region (9) of an outside of the window (2b) of the vehicle window (2) via the additional optics (15) and the objective (11).

9. Vehicle according to Claim 8 and having a camera arrangement according to Claim 7, **characterized in that** in order to adjust the imaging of a detected region (9) of the outside of the window (2b), the camera (1) can be adjusted on the camera holder (3), and/or the arrangement comprising objective (11) and imager (2) can be adjusted inside a camera housing (10), carried by the camera holder (3), in a direction (x) not parallel to the inside of the window (2a).

## Revendications

1. Caméra pour un véhicule, notamment pour la surveillance d'un espace, la caméra (1) comportant :
un dispositif d'imagerie (12) doté de plusieurs pixels (18a, 18b) ; et
un système optique supplémentaire (15) disposé devant le dispositif d'imagerie (12) et comprenant des microéléments optiques (26, 36), ledit système présentant des propriétés de déformation différentes pour les différentes zones de dispositif d'imagerie (12a, 12b) du dispositif d'imagerie (12), **caractérisée en ce que** :
un objectif (11) est disposé devant le dispositif d'imagerie (12) ;
le système optique supplémentaire (15) étant prévu entre l'objectif (11) et le dispositif d'imagerie (12) ;
les microéléments optiques étant des dispositifs luminoconducteurs (26, 36, 126, 39) placés devant le pixel (18a, 18b) d'une deuxième zone de dispositif d'imagerie (12b) et conduisant la lumière incidente vers un ou plusieurs pixels (18b) ;
aucun microélément optique n'étant disposé devant les pixels d'une première zone de dispositif d'imagerie (12a) ;
deux distances d'objet (g9) différentes étant compensées par l'agencement optique composé de l'objectif (11) et du système optique supplémentaire (15) respectivement prévu pour les deux zones de dispositif d'imagerie (12a, 12b) différentes, de façon à permettre leur déformation commune sur le dispositif d'imagerie (12).

2. Caméra selon la revendication 1, **caractérisée en ce que** le système optique supplémentaire (15) est fixé au dispositif d'imagerie (11) ou à un support de dispositif d'imagerie.

3. Caméra selon l'une quelconque des revendications précédentes, **caractérisée en ce que** la première zone de dispositif d'imagerie (12a) est orientée de façon infinie sur une distance d'objet pour détecter un environnement du véhicule (6) et que la deuxième zone de dispositif d'imagerie (12b) est orientée sur une distance d'objet finie, par exemple pour détecter un côté extérieur de vitre (2b) d'une vitre de véhicule (2).

4. Caméra selon l'une quelconque des revendications précédentes, **caractérisée en ce que** les dispositifs luminoconducteurs (26, 36, 126) sont des parois de séparation (36) réfléchissantes ou des tubes luminoconducteurs (26, 126).

5. Caméra selon la revendication 4, **caractérisée en ce que** les dispositifs luminoconducteurs (26, 36, 126, 39) prennent la forme de tubes luminoconducteurs (26), par exemple de fibres de verre (26) comportant des côtés supérieurs respectivement plans reposant dans un plan.

6. Caméra selon la revendication 5, **caractérisée en ce que** le système optique supplémentaire (15) comporte une ou plusieurs pièces d'espacement collées, à partir de plusieurs fibres de verre (26), par de la colle (38), pour former des chaînes.

7. Agencement de caméra composé d'une caméra (1) selon l'une quelconque des revendications précédentes et d'un support de caméra (3) pouvant être placé contre une vitre de véhicule (2), la focalisation ou l'ajustement de la déformation d'une zone déterminée (9) du côté extérieur de vitre (2b) étant possible par réglage de :
- la caméra (1) au niveau du support de caméra (3) ; et/ou
- l'agencement composé de l'objectif (11) et du dispositif d'imagerie (2) à l'intérieur d'un carter de caméra (10) maintenu par le support de caméra (3).

8. Véhicule doté d'une vitre de véhicule (2), notamment d'une vitre avant et d'une caméra (1), fixée à un côté intérieur de vitre (2a) par le biais d'un support de caméra (3), selon l'une quelconque des revendications 1 à 6, dont la première zone de dispositif d'imagerie (12a) déforme une première zone de détection (5) d'un environnement du véhicule (6) avec une distance d'objet plus importante via le système optique supplémentaire (15) et l'objectif (11) au travers de la vitre de véhicule (2) et dont la deuxième zone de dispositif d'imagerie (12b) déforme une zone (9) avec une distance d'objet (g9) plus petite, notamment une zone (9) d'un côté extérieur de vitre (2b) de la vitre de véhicule (2), via le système optique supplémentaire (15) et l'objectif (11).

9. Véhicule selon la revendication 8, doté d'un agencement de caméra selon la revendication 7, **caractérisé en ce que** l'ajustement de la déformation d'une zone détectée (9) du côté extérieur de vitre (2b) peut être réalisé par le biais de la caméra (1) au niveau du support de caméra (3) et/ou de l'agencement composé de l'objectif (11) et du dispositif d'imagerie (2) à l'intérieur d'un carter de caméra (10) supporté par le support de caméra (3) dans une direction (x) non parallèle au côté intérieur de vitre (2a).
